Europäisches Patentamt

European Patent Office

Office européen des brevets

(19)

(11) Numéro de publication : **0 025 376**
**B1**

(12)

# FASCICULE DE BREVET EUROPÉEN

(45) Date de publication du fascicule du brevet :
**11.05.83**

(51) Int. Cl.³ : **H 01 L 41/22**

(21) Numéro de dépôt : **80401184.9**

(22) Date de dépôt : **13.08.80**

(54) **Transducteur piézoélectrique en matériau polymère, et son procédé de fabrication.**

(30) Priorité : **21.08.79 FR 7921086**

(43) Date de publication de la demande :
**18.03.81 Bulletin 81/11**

(45) Mention de la délivrance du brevet :
**11.05.83 Bulletin 83/19**

(84) Etats contractants désignés :
**DE NL SE**

(56) Documents cités :
**EP A 0 002 161**
**GB A 1 501 921**
**GB A 2 020 483**

**PATENT ABSTRACTS OF JAPAN, vol. 1, no. 30, 29 mars 1977, page 1083E76**

(73) Titulaire : **THOMSON-CSF**
**173, Boulevard Haussmann**
**F-75379 Paris Cedex 08 (FR)**

(72) Inventeur : **Micheron, François**
**THOMSON -CSF SCPI 173, bld Haussmann**
**F-75360 Paris Cedex 08 (FR)**

(74) Mandataire : **Wang, Pierre et al**
**THOMSON-CSF SCPI 173, Bld Haussmann**
**F-75379 Paris Cedex 08 (FR)**

# 0 025 376

## Transducteur piézoélectrique en matériau polymère et son procédé de fabrication

La présente invention se rapporte aux transducteurs dont l'élément actif est constitué par un film de matériau polymère présentant des propriétés piézoélectriques et pyroélectriques semblables à celles que possèdent les corps appartenant à certaines classes de cristaux. L'acquisition des propriétés en question est basée sur la création d'une anisotropie électrique grâce à un champ électrique intense appliqué perpendiculairement aux faces principales du film polymère. Pour obtenir une polarisation électrique importante, il est utile d'étirer préalablement le film polymère, afin que les chaînes macromoléculaires présentent un moment dipolaire. L'étirement du film polymère précède la polarisation électrique, afin d'obtenir une anisotropie mécanique par amincissement qui est favorable à la formation d'une phase polaire. De tels transducteurs sont décrits dans la demande de brevet européen EP-A-0 002 161 déposée au nom de la Demanderesse.

Le matériau polymère de base le plus couramment utilisé pour fabriquer des transducteurs piézoélectriques ou pyroélectriques est le polyfluorure de vinylidène ($PVF_2$). Compte tenu de la faible épaisseur du film mis en œuvre pour réaliser ces transducteurs, il est avantageux de lui donner une forme autoportante par moulage ou thermoformage selon une surface non développable. La forme obtenue est polarisée électriquement au moyen d'électrodes recouvrant ces faces. Ces électrodes peuvent être solides, liquides ou gazeuses, mais l'opération de polarisation nécessite en général que le film thermoformé soit replacé sur un moule, car il a tendance à se recroqueviller dès qu'on le porte par chauffage à une température relativement élevée. Cette technique de fabrication est avantageuse dans la mesure où elle permet de réaliser des formes complexes qui peuvent correspondre à des allongements très importants. Cependant cette méthode ne donne pas entière satisfaction lorsque les formes désirées sont faiblement incurvées. L'arc-boutement entre appuis fixes d'une forme faiblement cintrée procure un effet amplificateur de déplacement qui est particulièrement utile en pratique pour obtenir une amplitude vibratoire importante. Toutefois, il faut s'assurer que les formes mettant en jeu cet effet aient des caractéristiques dimensionnelles très précises. La technique de fabrication par thermoformage est donc mal adaptée à la réalisation de formes simples nécessitant une grande stabilité dimensionnelle. Elle a aussi pour inconvénient de mettre en œuvre des opérations distinctes qui sont la mise en forme du film et ultérieurement sa polarisation électrique.

Il est également connu par le document GB-A-1 501 921 de polariser en continu un film de polymère en portant ce film à une température de polarisation grâce à un cylindre chauffant sur lequel ce film plan vient s'appuyer et à créer par décharge Corona une électrisation de la région chauffée donnant naissance à une orientation dipolaire rendue semi-permanente par refroidissement du film. Comme le film ainsi traité reste développable, l'obtention d'une structure auto-portante suppose un découpage avec refermeture selon une ou plusieurs lignes de jonction et il n'est pas question d'obtenir une structure non développable sans un traitement ultérieur qui peut faire perdre la polarisation électrique acquise antérieurement.

En vue de pallier ces inconvénients, l'invention prévoit de mettre en forme le film polymère en phase non polaire en le tendant sur une forme métallique et en provoquant la relaxation des tensions mécaniques ainsi créées sous l'action du champ électrique de polarisation transformant la phase non polaire en phase polaire.

L'invention a pour objet un procédé de fabrication d'un transducteur dont l'élément actif est constitué par un film de polymère polarisé électriquement selon une direction perpendiculaire à des faces et formant une structure autoportante, caractérisé en ce qu'il consiste à tendre un film plan de matériau polymère en phase $\alpha$ non polaire sur une surface conductrice non développable ; à électroformer ce film tendu à l'aide d'une décharge électrique ionisante produite au moyen d'une électrode munie de pointes qui surplombent cette surface conductrice et à munir d'électrodes les faces de la zone électroformée de ce film.

L'invention a également pour objet un transducteur piézoélectrique dont l'élément actif est constitué par un film de polymère formant une structure autoportante munie d'électrodes sur ses deux faces, caractérisé en ce que la partie du film comprise entre ces électrodes renferme au moins une zone électroformée mécaniquement relaxée et dotée d'une phase polaire.

L'invention sera mieux comprise au moyen de la description ci-après et des figures annexées parmi lesquelles :

la figure 1   montre comment on peut obtenir un film de polymère biétiré.

la figure 2   est une vue en coupe du film polymère de la figure 1.

la figure 3   est une vue isométrique d'un dispositif de polarisation utilisant la décharge par effet Corona.

la figure 4   est une figure explicative.

la figure 5   représente en (a) une chaîne macromoléculaire de polyfluorure de vinylidène dans la phase $\alpha$ non polaire et en (b) deux chaînes adjacentes en phase $\alpha_p$.

la figure 6   est une vue en coupe des moyens de mise en œuvre du procédé de fabrication selon l'invention.

la figure 7   représente en élévation et en plan un transducteur piézoélectrique conforme à l'invention.

2

# 0 025 376

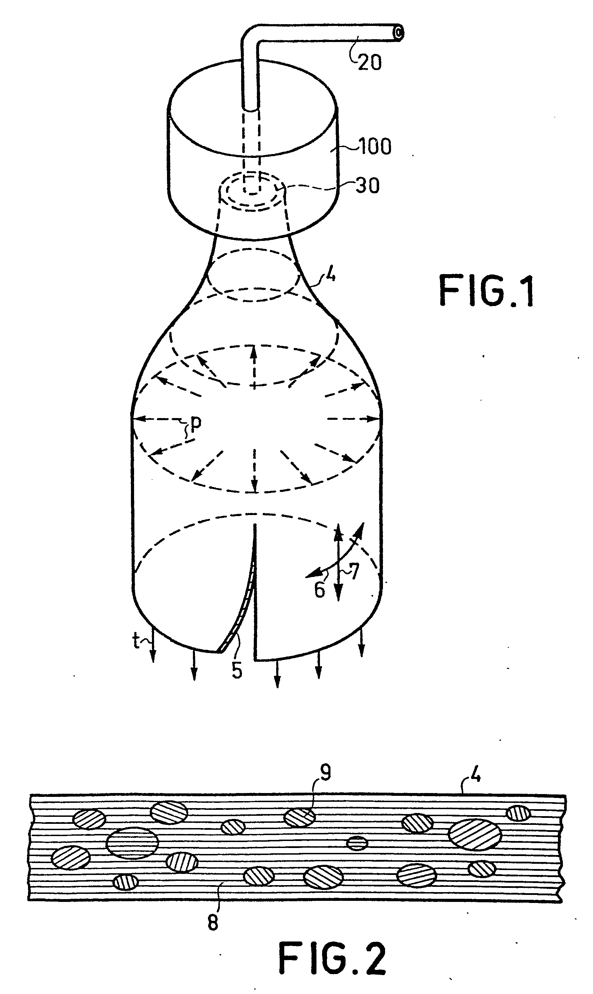

Sur la figure 1, on peut voir à titre d'exemple non limitatif un dispositif permettant de fabriquer par extrusion et soufflage un film de polymère tel que le polyfluorure de vinylidène.

Ce dispositif comporte un creuset 100 qui contient le polymère à une température voisine de celle de la fusion. Le fond du creuset est muni d'un orifice annulaire d'éjection 30 qui confère au polymère extrudé une forme tubulaire. Une conduite 20 communiquant avec la partie centrale délimitant l'orifice 30 permet l'insufflation d'un gaz à l'intérieur de la forme tubulaire extrudée. En raison de la pression intérieure p et de la traction t exercée sur la forme tubulaire 4, on obtient un évasement de l'enveloppe extrudée. Celle-ci se transforme à la partie inférieure en une gaine d'épaisseur uniforme qui peut se développer en un film plan biétiré lorsqu'on pratique une découpe 5. L'étirement circonférentiel 6 est produit par l'action de la pression p, tandis que l'étirement axial 7 résulte de la traction t.

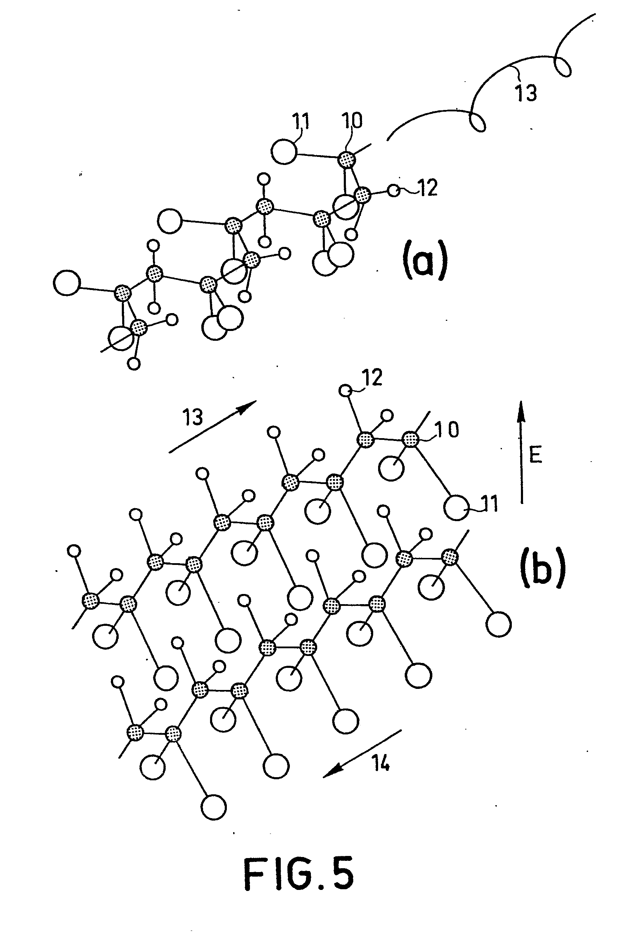

Le film 4 bi-étiré est plan après développement. La structure interne est composée d'amas cristallins 9 enfermés dans une matrice amorphe 8. Comme le film polymère bi-étiré est obtenu dans des conditions proches de l'état fondu, il est macroscopiquement isotrope dans son plan et les amas cristallins 9 sont peu aplatis. Le film biétiré est dans la phase $\alpha$ non polaire, car les chaînes macromoléculaires à l'intérieur des amas cristallins ont un agencement en hélice. Un tel agencement est représenté en (a) sur la figure 5. Les atomes de carbone 10, les atomes d'hydrogène 12 et les atomes de fluor 11 se disposent selon une chaîne macromoléculaire ayant une structure en hélice 13. Il existe également une autre phase $\beta$ où les chaînes macromoléculaires ont la configuration en zig-zag représentée en (b) sur la figure 5. On voit que la phase $\beta$ est polaire, mais dans le cas du polymère fondu elle est largement minoritaire par rapport à la phase $\alpha$ non polaire. Il est utile de rappeler que la phase $\alpha$ peut donner naissance à la phase polaire $\beta$ avec chaînes macromoléculaires en zig-zag, lorsqu'on étire le film polymère en deça de la température de fusion.

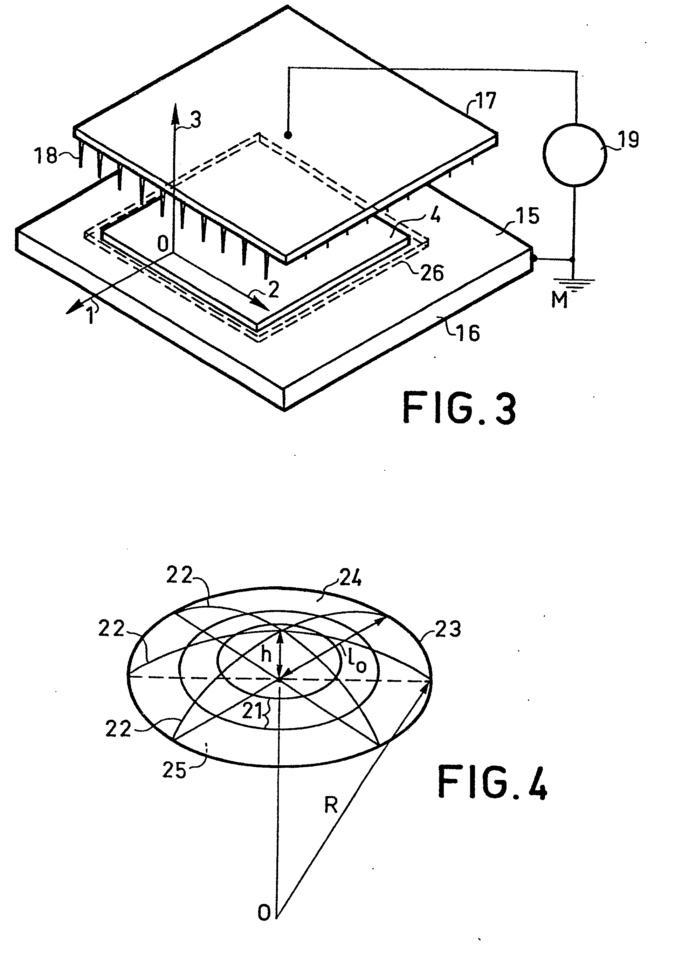

Sur la figure 3, on peut voir un dispositif permettant de polariser électriquement un film de polymère 4. Ce dispositif comporte une plaque conductrice 16 reliée à la masse M. Le film polymère 4 est déposé sur la face plane 15 de la plaque 16. Une électrode 17 munie de pointes 18 surplombe la surface 15. Un générateur à haute tension 19 est raccordé à la plaque 16 et à l'électrode 17. La tension de polarisation est choisie de manière à produire une décharge corona. L'ionisation engendrée par les pointes 18 permet de créer un champ électrique très intense au sein du film. En raison de la forte densité de charge existant sur les faces du film 4, une forte pression électrostatique tend à l'écraser, à tel point qu'il s'allonge et peut se plisser localement. On peut empêcher le plissement du film 4, en enduisant le plan conducteur 15 avec un lubrifiant approprié tel qu'une huile siliconée. Dans ces conditions, le film 4 polarisé suivant la direction 3 s'étend de façon isotrope dans les directions 1 et 2. L'allongement observé dans le cas d'un film de polymère bi-étiré est isotrope dans le plan contenant les directions 1 et 2 pour autant que son épaisseur soit uniforme. Après avoir appliqué la polarisation continue pendant une vingtaine de secondes, on peut observer un allongement permanent de plusieurs pourcents du film 4. Si à ce stade on inverse le signe de la polarisation, le film dont le contour atteignait le tracé pointillé 26 peut revenir à ses dimensions d'origine. Pour provoquer le retour aux dimensions initiales, il suffit de soumettre le film à une tension de polarisation inversée d'amplitude inférieure à celle qui avait servi à l'allonger. On peut faire suivre cette expérience d'une phase de polarisation avec une tension inverse augmentée, on constate alors que le film 4 s'étend à nouveau jusqu'au contour 26.

Pour fixer les idées, on peut utiliser un support 16 en aluminium poli convenablement lubrifié avec une électrode 17 dont les pointes 18 sont écartées de quinze millimètres de la surface 15.

En opérant à la température ambiante, un film 4 bi-étiré de polyfluorure de vinylidène ayant une épaisseur uniforme comprise entre 6 et 25 microns subit un allongement permanent de quelques pourcents lorsque la tension de polarisation appliquée crée au sein du film un champ électrique proche du champ électrique de claquage. Pour un film de 16 microns d'épaisseur la tension de polarisation requise pour l'électroformage du film 4 est de l'ordre de 15 kV. La déformation permanente est acquise après un temps d'application de la tension d'environ vingt secondes. Le film 4 est alors polarisé à saturation, car si l'on prolonge le temps de polarisation, les coefficients piézoélectriques n'augmentent pas. La mesure des coefficients piézoélectriques $d_{31}$ et $d_{32}$ conduit à des valeurs comprises entre 2 et $5.10^{-12}$ Coulomb/Newton. Les coefficients piézoélectriques $d_{31}$ et $d_{32}$ sont définis dans l'ouvrage « Physical Properties of Crystals » de J.F. NYE. OXFORD AT THE CLARENDON PRESS, 1976, plus particulièrement aux pages 110 et suivantes.

On peut fournir l'interprétation suivante des phénomènes observés. Le film dans l'état initial a été biétiré à une température voisine de celle de la fusion, de sorte qu'il est constitué principalement par la phase $\alpha$ isotrope non polaire. Ceci est confirmé par l'examen des spectres d'absorption en infrarouge et l'on peut se reporter à l'illustration (a) de la figure 5 qui montre la configuration d'un chaîne macromoléculaire. Lorsque le film a reçu une première polarisation, la phase $\alpha$ se transforme en phase dite $\alpha_p$ où une chaîne sur deux se retourne de façon que les dipoles associés à deux chaînes voisines et parallèles ajoutent leurs effets. Cette situation est illustrée en (b) sur la figure 5. Sur la base des examens de diffraction X, on constate que la chaîne qui se retourne doit se translater par rapport à sa voisine non retournée. Ces translations sont représentées en (b) sur la figure 5 par les flèches 13 et 14 et se produisent sous l'action du champ électrique polarisateur E. On est enclin à supposer que les actions de retournement et glissement qui viennent d'être mentionnées sont de nature à entraînement dans les zones cristallines du polymère des modifications de dimensions qui ont pour répercussion l'extension

3

observée macroscopiquement.

Cette interprétation est d'autant plus plausible qu'elle justifie la rétraction observée sous polarisation inversée d'intensité moyenne et l'allongement qui réapparaît lorsque la polarisation inverse sature à nouveau le film.

Une variante de l'expérience décrite précédemment vient encore renforcer le caractère plausible de l'interprétation donnée ci-dessus. Avant polarisation électrique, on met sous tension mécanique le film 4. Pour cela, on tend le film 4 sur le support 16 et on le maintient dans l'état déformé 26 au moyen de rubans adhésifs bordant ce contour. On polarise ensuite le film 4 et l'on constate que les tensions mécaniques qui existaient selon les directions 1 et 2, se sont relaxées. Après enlèvement des rubans adhésifs, le film conserve la forme étendue 26. Si l'on dépose sur les deux faces du film 4 des électrodes et si l'on applique à ces électrodes une tension alternative afin que l'ensemble fonctionne comme transducteur piézoélectrique, le film vibre en épaisseur et subit des allongements isotropes dans son plan, mais cette tension alternative d'excitation n'a aucune influence néfaste sur la polarisation et l'extension acquise au cours de l'opération d'électroformage.

L'électroformage d'un film polymère présente un réel intérêt lorsqu'il s'agit de donner à un film plan d'épaisseur uniforme une forme autoportante. En effet, un film plan très mince est dépourvu de résistance mécanique aux sollicitations agissant perpendiculairement à sa surface. Il est donc nécessaire de le tendre sur un support incurvé ce qui complique la réalisation d'un transducteur et tend à en diminuer les performances. En outre, un film plan se prête mal à la mise en œuvre d'un effet d'arcboutement qui permet de convertir de faibles allongements suivant les directions 1 et 2 en un déplacement fortement amplifié dans la direction 3.

Sur la figure 4, on a représenté une surface non développable en forme de calotte sphérique 24. Le rayon de courbure de cette calotte est R, sa hauteur est h et le diamètre de son pourtour 23 est 2 $l_o$.

En supposant que le contour 23 ait été tracé sur un film plan élastique 25 et que ce film ait été déformé pour épouser la forme de la calotte 23, on peut tenter d'évaluer les allongements subis par le film en fonction des données h, $l_o$ et R. Le passage de la forme plane à la forme sphérique implique des allongements variant le long des méridiens 22 et dont les valeurs sont distinctes selon les parallèles 21. En effet, l'allongement est nul en ce qui concerne le contour 23 et il est essentiellement dirigé selon les méridiens 22 à proximité du contour 23.

Par contre, on peut évaluer aisément l'accroissement relatif $\Delta S/S$ de surface du film et en déduire un allongement proportionnel $\Delta l/l$ moyen supposé isotrope qui donne une bonne idée des possibilités d'électroformage. Les principaux résultats d'un tel calcul sont les suivants :

$$R = h^2 + l_o^2/2h \qquad (1)$$

$$\Delta S/S = h^2/l_o^2 = 2(\Delta l/l) + (\Delta l/l)^2$$

le second terme de cette expression considère que le disque plan de la figure 4 a une aire S accrue de $\Delta S$ par la transformation en calotte sphérique alors que le terme de droite relie la dilatation linéaire isotrope d'un disque plan à la variation relative de surface.

D'où l'on tire :

$$\Delta l/l = \sqrt{1 + h^2/l_o^2} - 1$$

C'est-à-dire, si $h/l_o \ll 1$

$$\Delta l/l \simeq 1/2\, h^2/l_o^2 \qquad (2)$$

A titre d'exemple numérique, avec $l_o$ = 4 cm et un allongement proportionnel isotrope $\Delta l/l = 2.10^{-2}$, on obtient les dimensions suivantes :

$$h = \sqrt{2\, l_o^2\, \Delta l/l} = 0,8 \text{ cm}$$

$$R = h^2 + l_o^2/2\, h = 10,4 \text{ cm}$$

Les résultats qui précèdent montrent que l'électroformage conduit à des structures autoportantes dont le cintrage est suffisant pour assurer la bonne tenue du film. Comme le film polymère est calibré en épaisseur, la zone électroformée peut être polarisée à saturation dans toute son étendue, ce qui assure un fonctionnement très homogène du transducteur aussi bien dans les applications piézoélectriques que dans les applications pyroélectriques.

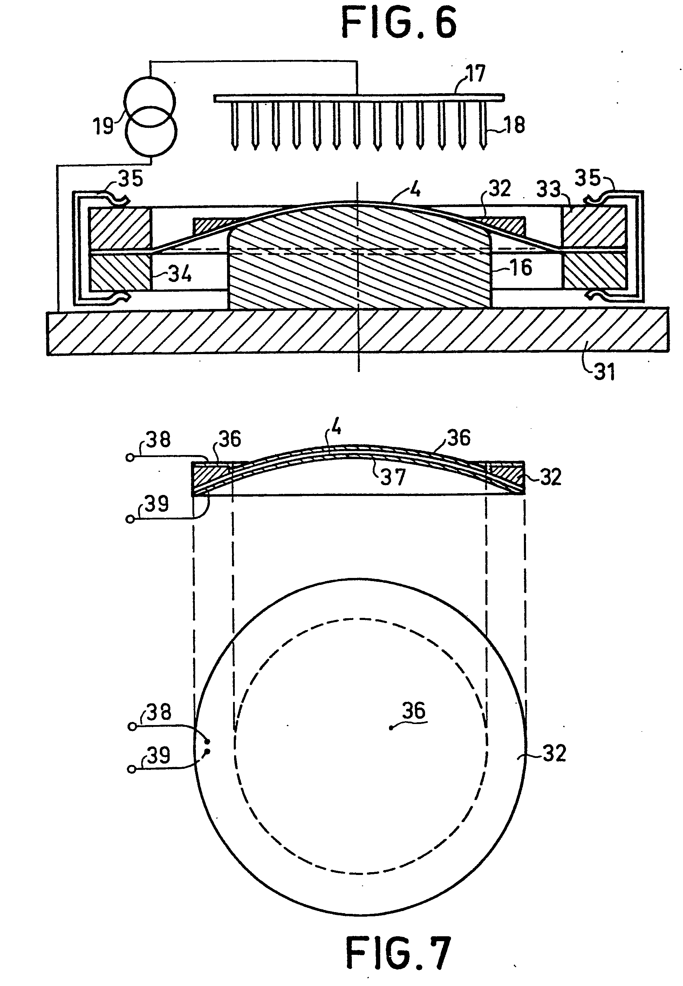

La figure 6 représente un dispositif destiné à la mise en œuvre du procédé d'électroformage selon l'invention. Il comprend une table 31 reliée à la masse d'un générateur électrique 19. Un moule conducteur 16 repose sur la table 31. Sa face supérieure lubrifiée épouse la forme convexe d'une calotte sphérique. Un film de matériau polymère 4 est pincé à l'état plan entre deux anneaux 33 et 34 maintenus serrés l'un contre l'autre par des pinces 35. L'ensemble formé par le film 4 et le cadre annulaire 33, 34, 35 vient coiffer la face supérieure du moule 16. Sous l'action du poids et le cas échéant d'une poussée verticale, le film 4 se tend sur le moule 4 en épousant étroitement la forme de sa face supérieure. Une électrode 17 reliée au générateur 19 est placée en surplomb de la zone étirée du film 4 ; cette électrode est munie de pointes 18 qui permettent d'obtenir une décharge corona. Une pièce annulaire 32 peut être fixée sur le pourtour du film 4 avant l'application de la tension électrique d'électroformage. Cette pièce annulaire 32 très rigide ceinture le film 4 dans la zone en forme de calotte sphérique.

Lorsqu'on applique la tension électrique de polarisation, les tensions mécaniques se relaxent dans la zone cintrée du film 4 qui est comprise à l'intérieur de la collerette 32. Les tensions mécaniques subsistent dans la zone annulaire tendue du film 4 qui entoure la collerette 32, car le champ électrique est faible dans cette dernière zone. Une fois l'électroformage terminé, on peut retirer le cadre de pinçage 33, 34 et le démonter. On obtient ainsi un élément transducteur tel que représenté en élévation et en plan sur la figure 7.

L'élément transducteur de la figure 7 est obtenu en arasant le film 4 qui dépasse le contour de la collerette 32. Des dépôts conducteurs 36 et 37 sont effectués sur les faces principales du film 4. L'un de ces dépôts peut sans inconvénient recouvrir la collerette 32. Des fils d'alimentation 38 et 39 sont reliés aux dépôts 36 et 37, afin de permettre l'application d'une tension alternative d'excitation dans le cas du fonctionnement en moteur piézoélectrique. Les fils 38 et 39 servent à recueillir une tension électrique lors du fonctionnement inverse en capteur piézoélectrique de vibration et lors de l'utilisation comme détecteur pyroélectrique de rayonnement.

Il y a lieu de signaler que la fixation de la collerette 32 peut avoir lieu après l'électroformage du film 4. Les zones tendues du film 4 non soumises au champ d'électroformage peuvent se détendre grâce au relachement des tensions dans la partie centrale du film 4, mais ces zones non électroformées conservent la forme plane du film 4 non tendu.

Le transducteur de la figure 7 constitue avantageusement un haut-parleur piézoélectrique utilisable entre 8 et 40 kHz. Dans ce cas, on peut réaliser la collerette 32 en acier et réaliser le dépôt 36 et 37 par évaporation sous vide d'aluminium.

La structure de la figure 7 se prête bien à la réalisation de membranes d'écouteurs piézoélectriques et de diaphragmes pour microphones piézoélectriques. Elle peut également servir de capteur pyroélectrique, notamment pour la détection d'intrus et pour la détection d'incendie.

Bien que l'on ait décrit dans ce qui précède et représenté sur les dessins, les caractéristiques essentielles de la présente invention appliquées à un mode de réalisation préféré de celle-ci il est évident que l'homme de l'art peut y apporter toutes modifications de forme ou de détail qu'il juge utiles, sans pour autant sortir du cadre de ladite invention. En particulier, le film de polymère peut également être obtenu en dissolvant le polymère dans un solvant pour former une couche mince qui se transforme en film solide après évaporation du solvant. L'électroformage n'est pas limité à une forme sphérique ayant un périmètre circulaire. Toute forme autoportante permettant de tendre le film de façon à y créer des allongements de quelques pourcents est appropriée. La mise sous tension du film peut être réalisée au moyen d'un cadre de pinçage et d'un moule convexe, mais on peut également prévoir une mise sous tension mécanique par l'action d'un gaz sous pression ou par aspiration.

## Revendications

1. Procédé de fabrication d'un transducteur dont l'élément actif est constitué par un film de polymère (4) polarisé électriquement selon une direction (3) perpendiculaire à ses faces et formant une structure autoportante, caractérisé en ce qu'il consiste à tendre un film plan de matériau polymère en phase α non polaire sur une surface conductrice (16) non développable, à électroformer ce film tendu à l'aide d'une décharge électrique ionisante produite au moyen d'une électrode (17) munie de pointes (18) qui surplombent cette surface conductrice et à munir d'électrodes (36 et 37) les faces de la zone électroformée de ce film.

2. Procédé selon la revendication 1, caractérisé en ce que la surface conductrice (16) est de forme bombée et en ce que le film plan (4) pincé dans un cadre rigide (33, 34) est pressé contre cette surface conductrice de façon à en épouser la forme.

3. Procédé selon la revendication 2, caractérisé en ce que la zone électroformée du film est cerclée par une collerette rigide (32) préalablement à l'application de la décharge électrique ionisante.

4. Transducteur piézoélectrique dont l'élément actif est constitué par un film de polymère (4) formant une structure autoportante munie d'électrodes (36, 37) sur ses deux faces, caractérisé en ce que la partie du film comprise entre ces électrodes renferme au moins une zone électroformée mécaniquement relaxée et dotée d'une phase polaire.

5. Transducteur selon la revendication 4, caractérisé en ce que la structure auto-portante est une forme bombée.

6. Transducteur selon l'une quelconque des revendications 4 et 5, caractérisé en ce qu'il comprend une collerette rigide (32) cerclant la zone électroformée.

7. Transducteur selon l'une quelconque des revendications 4 à 6, caractérisé en ce que le film de polymère (4) est un film de polyfluorure de vinylidène.

**Claims**

1. Method of producing a transducer, the active element of which is formed by a polymer film (4) electrically polarized in a direction (3) perpendicular to its faces and forming a self-supporting structure, characterized in that it consists in stretching a plane film of nonpolar α phase polymer material on a non-developable conductive surface (16), in electroshaping this stretched film by means of an ionizing electric discharge produced by means of an electrode (17) having tips (18) arranged perpendicularly above this conductive surface, and in providing the faces of the electroshaped zone of this film with electrodes (36 and 37).

2. Method in accordance with claim 1, characterized in that the conductive surface (16) is of domed form and in that the plane film (4) clamped in a rigid frame (33) is pressed against this conductive surface in a manner to follow its shape.

3. Method in accordance with claim 2, characterized in that the electroshaped zone of the film is surrounded by a rigid ring (32) prior to the application of the ionizing electric discharge.

4. Piezoelectric transducer, the active element of which is formed by a polymer film (4) forming a self-supporting structure provided with electrodes (36, 37) on both faces, characterized in that the portion of the film comprised between these electrodes includes at least one mechanically relaxed electroshaped zone having a polar phase.

5. Transducer in accordance with claim 4, characterized in that the self-supporting structure is of domed shape.

6. Transducer in accordance with any of claims 4 and 5, characterized in that it comprises a rigid ring (32) surrounding the electroshaped zone.

7. Transducer in accordance with any of claims 4 to 6, characterized in that the polymer film (4) is a polyvinylidene fluoride film.

**Ansprüche**

1. Verfahren zur Herstellung eines Wandlers, dessen aktives Element aus einem eine selbsttragende Struktur bildenden Polymerfilm (4) gebildet ist, der elektrisch in einer Richtung (3) polarisiert ist, die senkrecht zu seinen Flächen ist, dadurch gekennzeichnet, daß es darin besteht, einen ebenen Film aus Polymermaterial in der unpolaren Phase α auf eine nicht abwickelbare leitende Oberfläche (16) zu spannen, diesen gespannten Film elektrisch zu formen mittels einer ionisierenden elektrischen Entladung, die durch eine Elektrode (17) hervorgerufen wird, welche mit Spitzen (18) versehen ist, die senkrecht über dieser leitenden Oberfläche angeordnet sind, und daß die Flächen der elektrisch geformten Zone dieses Filmes mit Elektroden (36 und 37) versehen werden.

2. Verfahren nach Anspruch 1, dadurch gekennzeichnet, daß die leitende Oberfläche (16) eine gewölbte Form aufweist und daß der ebene Film (4), der in einem starren Rahmen (33, 34) eingeklemmt ist, so gegen diese leitende Oberfläche gepreßt wird, daß er ihre Form annimmt.

3. Verfahren nach Anspruch 2, dadurch gekennzeichnet, daß die elektrisch geformte Zone des Filmes vor der Anwendung der elektrischen ionisierenden Entladung durch einen starren Kranz (32) umringt wird.

4. Piezoelektrischer Wandler, dessen aktives Element aus einem Polymerfilm (4) gebildet ist, der eine selbsttragende, auf seinen beiden Flächen mit Elektroden (36, 37) versehene Struktur bildet, dadurch gekennzeichnet, daß derjenige Teil des Filmes, der zwischen diesen Elektroden enthalten ist, wenigstens eine mechanisch entspannte elektrogeformte Zone einschließt, die mit einer polaren Phase versehen ist.

5. Wandler nach Anspruch 4, dadurch gekennzeichnet, daß die selbsttragende Struktur eine gewölbte Struktur ist.

6. Wandler nach Anspruch 4 oder 5, dadurch gekennzeichnet, daß er einen starren Kranz (32) umfaßt, der die elektrogeformte Zone umringt.

7. Wandler nach einem der Ansprüche 4 bis 6, dadurch gekennzeichnet, daß der Polymerfilm (4) ein Film aus Polyvinylidenfluorid ist.

FIG.1

FIG.2

FIG.3

FIG.4

FIG.5

# FIG. 6

# FIG. 7